# EUROPÄISCHE PATENTSCHRIFT

(11) **EP 0 941 591 B1**
(45) Veröffentlichungstag und Bekanntmachung des Hinweises auf die Patenterteilung: **27.02.2002**
(21) Anmeldenummer: 97952818.9
(22) Anmeldetag: 28.11.1997
(51) Int. Cl.: H04L 1/20

(54) **DURCHGANGSMODULATOR ZUM VERJITTERN VON SIGNALEN**
TRANSIT MODULATOR FOR JITTERING SIGNALS
MODULATEUR DE TRANSIT SERVANT A SOUMETTRE DES SIGNAUX A UNE GIGUE

(30) Priorität: 29.11.1996 DE 19650839
(43) Veröffentlichungstag der Anmeldung: 15.09.1999
(73) Patentinhaber: Tektronix, Inc., Beaverton, OR 97077-0001 (US)
(72) Erfinder: MÄRZ, Freimut, D-85764 Oberschleissheim (DE)
(74) Vertreter: Schurack, Eduard F.
(86) Internationale Anmeldenummer: EP9706635
(87) Internationale Veröffentlichungsnummer: WO9824203

(56) Entgegenhaltungen:
- EP-A- 0 399 359
- DE-A- 2 536 268
- GB-A- 2 146 205
- US-A- 4 539 518
- US-A- 5 574 451
- PATENT ABSTRACTS OF JAPAN vol. 018, no. 378 (E-1579), 15.Juli 1994 & JP 06 105286 A (FUJITSU GENERAL LTD), 15.April 1994,
- PATENT ABSTRACTS OF JAPAN vol. 018, no. 623 (E-1635), 28.November 1994 & JP 06 237420 A (CLARION CO LTD), 23.August 1994,

## Beschreibung

Die Erfindung bezieht sich auf einen Durchgangsmodulator zum Verjittern eines Signals mit einem Speicher, einem an den Speicher angeschlossenen, einen unverjitterten Einlesetakt abgebenden Taktgenerator und einem an den Speicher angeschlossenen, einen verjitterten Auslesetakt abgebenden weiteren Taktgenerator.

Ein Durchgangsmodulator dieser Art ist beispielsweise aus dem Service-Handbuch zum SDH/PDH-Analysator K4312 der Siemens AG bekannt (Seiten 5-5 und 9-36). Bei dem bekannten Durchgangsmodulator ist ein Speicher mit einer zugehörigen Speicher- und Ausleseelektronik in einem ASIC (application-specific-IC) - Baustein integriert. Mit dem bekannten Durchgangsmodulator lassen sich binäre digitale Signale verjittern.

Ein vergleichbarer Durchgangsmodulator wird im Rahmen der DE-A-25 36 268 im Zusammenhang mit einem Simulator zur Nachbildung der charakteristischen Laufzeit- und/oder Phasenschwankungen (Jitter) digitaler Informationsflüsse auf Übertragungswegen beschrieben.

Aus der JP-A-06 105 286 wird im Zusammenhang mit der Kompensation eines Videojitters ein analoges Videoeingangssignal in ein digitales Signal unter Verwendung eines ersten Kontaktsignals-konvertiert und in einem Videospeicher abgespeichert. Pro Zeile wird eine Durchschnittszeit berechnet, sowohl von einem horizontalen Synchronisationssignal als auch einem vertikalen Synchronisationssignal. Ein zweites Taktsignal, das dem Durchschnittszeitpunkt entspricht, wird von einem VCO erzeugt. Die aus dem Speicher ausgelesenen Videodaten werden einer D/A-Umwandlung unterzogen unter Verwendung des zweiten Taktsignals. Die D/A-Umwandlung wird zu jedem Durchschnittszeitpunkt durchgeführt, so daß, selbst wenn der Jitter in einer durchgeführt, so daß, selbst wenn der Jitter in einer Eingangsstufe erzeugt wurde, der Jitter bei der nach dem Auslesen aus dem Speicher stattfindenden D/A-Umwandlung kompensiert wird.

Der Erfindung liegt die Aufgabe zugrunde, einen Durchgangsmodulator anzugeben, mit dem beliebige Signale verjittert werden können, sowie ein entsprechendes Verfahren bereitzustellen.

Diese Aufgabe wird erfindungsgemäß von einem Durchgangsmodulator mit den Merkmalen von Anspruch 1 gelöst bzw. durch ein Verfahren mit den Merkmalen des, Anspruchs 2.

Der Vorteil des erfindungsgemäßen Durchgangsmodulators besteht darin, daß durch den A/D-Wandler und den D/A-Wandler auch nichtbinäre digitale Signale, wie z.B. 2B1Q- oder 4B3T-Signale, und analoge Signale verjittert werden können.

Der obengenannten Druckschrift läßt sich auch ein Verfahren zum Verjittern eines Signals entnehmen, bei dem das Signal kennzeichnende Binärwerte mit einem unverjitterten Einlesetakt in einem Speicher abgespeichert und anschließend mit einem verjitterten Auslesetakt ausgelesen werden und aus den ausgelesenen Binärwerten ein verjittertes Signal erzeugt wird.

Der Vorteil des erfindungsgemäßen Verfahrens besteht darin, daß durch die A/D-Wandlung und die D/A-Wandlung nicht nur binäre digitale Signale, sondern auch nichtbinäre digitale Signale, wie z.B. 2B1Q- oder 4B3T-Signale, und analoge Signale verjittert werden können.

Zur Erläuterung der Erfindung ist in einer Figur ein Ausführungsbeispiel eines Durchgangsmodulators zum Verjittern eines Signals dargestellt.

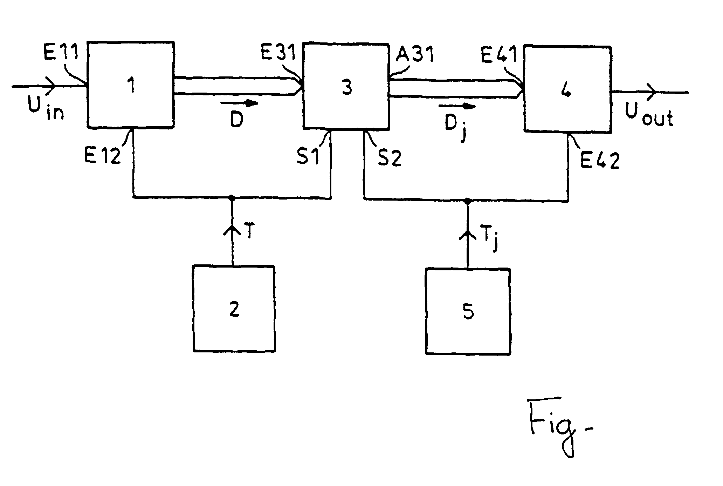

Die Figur zeigt einen A/D-Wandler 1 mit einem Eingang E11 und einem weiteren Eingang E12, dem ein Taktgenerator 2 vorgeschaltet ist. Der A/D-Wandler 1 ist ausgangsseitig mit einem Eingang E31 eines Speichers 3 verbunden. Der Speicher kann beispielsweise ein FIFO (first in first out) -Speicher sein. Einem Ausgang A31 des Speichers 3 ist ein D/A-Wandler 4 mit einem Eingang E41 nachgeordnet. Ein weiterer Eingang E42 des D/A-Wandlers 4 ist mit einem weiteren Taktgenerator 5 verbunden. Der Speicher 3 weist zwei Steuereingänge S1 und S2 auf, wobei der eine Steuereingang S1 mit dem einen Taktgenerator 2 und der weitere Steuereingang S2 mit dem weiteren Taktgenerator 5 verbunden ist. Ein Ausgang des D/A-Wandlers 4 bildet den Ausgang des erfindungsgemäßen Durchgangsmodulators. Ein Signal Uᵢₙ wird in den A/D-Wandler 1 eingespeist, in dem es mit einem vom Taktgenerator 2 vorgegebenen unverjitterten Takt T abgetastet und unter Bildung von Binärwerten analog/digital gewandelt wird. Die Binärwerte bilden einen binären Datenstrom D, der in paralleler Übertragung zum Speicher 3 übertragen wird. Im Speicher 3 werden die Binärwerte des binären Datenstroms D mit dem durch den Taktgenerator 2 vorgegebenen Takt T abgespeichert.

Anschließend werden die Binärwerte mit einem vom weiteren Taktgenerator 5 vorgegebenen verjitterten Takt Tⱼ aus dem Speicher 3 unter Bildung eines verjitterten Datenstromes Dⱼ ausgelesen. Dabei wird die Reihenfolge, mit der die Binärwerte im Speicher 3 abgespeichert wurden, beim Auslesen berücksichtigt, und zwar in der Weise, daß zuerst abgepeicherte Binärwerte auch zuerst ausgelesen werden.

Der vom weiteren Taktgenerator 5 bereitgestellte Takt Tj stellt einen gegenüber dem Takt T des Taktgenerators 2 verjitterten Takt gleicher Frequenz dar, so daß beim Auslesen der Binärwerte aus dem Speicher 3 der verjitterte Datenstrom Dⱼ entsteht. Dieser gelangt in paralleler Übertragung zu dem mit dem verjitterten Takt Tⱼ beaufschlagten D/A-Wandler 4, in dem aus dem verjitterten Datenstrom Dj bzw. aus den in ihm enthaltenen Binarwerten durch D/A-Wandlung ein gegenüber dem Signal Uᵢₙ verjittertes Signal Uₒᵤₜ gebildet wird.

Die Übertragung des binären Datenstroms D zwischen dem A/D-Wandler 1 und dem Speicher 3 erfolgt in paralleler Übertragung, d.h. alle zu einem Abtastzeitpunkt erzeugten Binärwerte werden gleichzeitig zum Speicher 3 übertragen. Das gleiche gilt entsprechend für die Übertragung der ausgelesenen Binarwerte zwischen dem Speicher 3 und dem D/A-Wandler 4. Soll die Übertragung der Binärwerte zwischen dem A/D-Wandler 1 und dem Speicher 3 bzw. zwischen dem Speicher 3 und dem D/A-Wandler 4 stattdessen seriell erfolgen, müssen der Takt beim Abtasten im A/D-Wandler 1 und der Takt beim Abspeichern der Binarwerte im Speicher 3 sowie der verjitterte Takt beim Auslesen der Binärwerte aus dem Speicher 3 und der verjitterte Takt beim D/A-Wandler 4 entsprechend aufeinander abgestimmt sein.

Mit der erfindungsgemäßen Anordnung lassen sich sowohl binare digitale Signale als auch nichtbinäre digitale Signale wie z.B. 2B1Q- oder 4B3T-Signale und analoge Signale verjittern.

## Patentansprüche

1. Durchgangsmodulator zum Verjittern eines Signals (Uᵢₙ) mit
- einem Speicher (3),
- einem an den Speicher (3) angeschlossenen, einen unverjitterten Einlesetakt (T) abgebenden Taktgenerator (2), und
- einem an den Speicher (3) angeschlossenen, einen verjitterten Auslesetakt (Tⱼ) abgebenden weiteren Taktgenerator (5),
**dadurch gekennzeichnet,**
**daß** dem Speicher (3) ein A/D-Wandler (1) vor- und ein D/A-Wandler (4) nachgeschaltet ist, wobei die Taktung des A/D-Wandlers (1) mit dem unverjitterten Einlesetakt (T) und die Taktung des D/A-Wandlers (4) mit dem verjitterten Auslesetakt (Tⱼ) korreliert ist.

2. Verfahren zum Verjittern eines Signals (Uᵢₙ), bei dem
- das Signal (Uᵢₙ) kennzeichnende Binärwerte mit einem unverjitterten Einlesetakt (T) in einem Speicher (3) abgespeichert werden und anschließend mit einem verjitterten Auslesetakt (Tⱼ) ausgelesen werden, und
- aus den ausgelesenen Binärwerten ein verjittertes Signal (Uₒᵤₜ) erzeugt wird,
**dadurch gekennzeichnet, daß**
- das Signal (Uᵢₙ) unter Bildung von Abtastwerten abgetastet wird,
- aus den Abtastwerten die das Signal (Uᵢₙ) kennzeichnenden Binärwerte durch A/D-Wandlung gewonnen werden und
- durch D/A-Wandlung der ausgelesenen Binärwerte das verjitterte Signal (Uₒᵤₜ) erzeugt wird, wobei die Taktung der A/D-Wandlung mit der Abspeicherung im Speicher (3) korreliert ist, und die Taktung der D/A-Wandlung mit dem Auslesen aus dem Speicher (3) korreliert ist.

## Claims

1. A transit modulator for jittering a signal (Uᵢₙ) with
- a memory (3)
- a clock generator (2) coupled to the memory (3) generating a non-jittered read-in clock (T), and
- an additional clock generator (5) coupled to the memory (3) generating a jittered read-out clock (Tⱼ),
**characterized in that**
connected to the memory (3) on the incoming circuit is an A/D converter (1) and connected to the memory (3) on the outgoing circuit is a D/A converter (4), in which the timing of the A/D converter (1) is correlated with the non-jittered read-In clock (T) and the timing of the D/A converter (4) is correlated with the jittered read-out clock (Tⱼ).

2. A method for jittering a signal (Uᵢₙ) in which
- binary values **characterizing** said signal (Uᵢₙ) are stored in a memory (3) with a non-jittered read-in clock (T) and are subsequently read out with a jittered read-out clock (Tⱼ), and
- a jittered signal (Uₒᵤₜ) is generated from the binary values read out
**characterized in that**
- said signal (Uᵢₙ) is sampled forming samples,
- the binary values **characterizing** said signal (Uᵢₙ) are obtained from said samples by A/D conversion, and
- the jittered signal (Uₒᵤₜ) is generated by means of D/A conversion of the binary values read out, with the timing of the A/D conversion being correlated with the storing in memory (3) and the timing of the D/A conversion being correlated with the reading out from memory (3).

## Revendications

1. Modulateur de transit pour la mise en gigue d'un signal (Uᵢₙ), comprenant
- une mémoire (3)
- un générateur d'impulsions (2) relié à la mémoire (3) et émettant une impulsion d'entrée non mise en gigue(T), et
- un autre générateur d'impulsions (5) relié à la mémoire (3) et émettant une impulsion de sortie mise en gigue(Tⱼ),
**caractérisé en ce**
**qu'**un convertisseur A/D (1) est placé en amont de ladite mémoire (3), et un convertisseur D/A (4) est placé en aval de ladite mémoire (3), le rythme du convertisseur A/D (1) étant en corrélation avec l'impulsion d'entrée non mise en gigue (T), et le rythme du convertisseur D/A (4) étant en corrélation avec l'impulsion de sortie mise en gigue (Tⱼ).

2. Procédé pour la mise en gigue d'un signal (Uᵢₙ), dans lequel
- des valeurs binaires caractérisant le signal (Uᵢₙ) sont mémorisées avec une impulsion d'entrée non mise en gigue (T) dans une mémoire (3), et sont ensuite extraites avec une impulsion de sortie mise en gigue (Tⱼ), et
- un signal mis en gigue (Uₒᵤₜ) est généré à partir des valeurs binaires extraites,
**caractérisé en ce que**
- ledit signal (Uᵢₙ) est balayé sous formation de valeurs de balayage,
- à partir desdites valeurs de balayage, les valeurs binaires caractérisant le signal (Uᵢₙ) sont obtenues par conversion A/D, et
- ledit signal mis en gigue (Uₒᵤₜ) est généré par conversion D/A des valeurs binaires extraites, le rythme de la conversion A/D étant en corrélation avec la mémorisation dans la mémoire (3), et le rythme de la conversion D/A étant en corrélation avec l'extraction de la mémoire (3).
